Europäisches Patentamt

European Patent Office

Office européen des brevets

(19)

(11) **EP 0 674 806 B1**

(12) # EUROPEAN PATENT SPECIFICATION

(45) Date of publication and mention
of the grant of the patent:
**10.06.1998 Bulletin 1998/24**

(51) Int Cl.6: **H01L 21/70**, H01L 21/20,
H01L 29/16

(21) Application number: **93901123.5**

(22) Date of filing: **18.12.1992**

(86) International application number:
**PCT/US92/11068**

(87) International publication number:
**WO 94/15359 (07.07.1994 Gazette 1994/15)**

(54) **SILICON ON DIAMOND CIRCUIT STRUCTURE AND METHOD OF MAKING SAME**

SILIZIUM-AUF-DIAMANT-SCHALTUNGSSTRUKTUR UND HERSTELLUNGSVERFAHREN DAFÜR

STRUCTURE DE CIRCUIT DE SILICIUM SUR ISOLANT EN DIAMANT ET PROCEDE DE
FABRICATION

(84) Designated Contracting States:
**DE FR GB IT NL**

(43) Date of publication of application:
**04.10.1995 Bulletin 1995/40**

(73) Proprietor: **HARRIS CORPORATION**
**Melbourne, FL 32901 (US)**

(72) Inventors:
• **SCHRANTZ, Gregory, A.**
**Melbourne, FL 32935 (US)**
• **GAUL, Stephen, J.**
**Melbourne, FL 32901 (US)**

(74) Representative: **Meddle, Alan Leonard**
**FORRESTER & BOEHMERT**
**Franz-Joseph-Strasse 38**
**80801 München (DE)**

(56) References cited:
**EP-A- 0 317 124        WO-A-91/11822**
**US-A- 4 554 059        US-A- 4 962 062**

• **Appl. Phys. Lett, Volume 56, No. 23, June 1990,
M. I. Landstrass et al, "Total dose radiation
hardness of diamond-based silicon-on-insulator
structures" page 2316 - page 2318**
• **Proceedings of the IEEE, Volume 79, No. 5, May
1991, W. Zhu et al, "Growth an Characterization
of Diamond Films on Nondiamond Substrates
for Electronic Applications" page 621 - page 646**

**Description**

FIELD OF THE INVENTION

This invention relates to integrated circuitry of the type formed with electrically isolated devices and, more particularly, to a dielectrically isolated structure providing improved circuit capabilities.

BACKGROUND OF THE INVENTION

A variety of techniques have been employed to achieve device isolation in integrated circuitry. These include junction isolation, formation of channel stops with dopant implants and the inclusion of dielectric material, e.g., by local oxidation of silicon. For the silicon planar process the class of dielectric isolation commonly referred to as *silicon on insulator* (SOI), is used to form individual devices on discrete islands or mesas. Advantages of SOI technology include improved power handling capability, avoidance of latch-up problems associated with junction isolation, and improvements in transistor operating frequency, the latter resulting from lower output capacitance attributable to the dielectric isolation. Generally SOI structures exhibit greater tolerance and immunity to the effects of ionizing radiation and, therefore, are the structure of choice for rad hard environments.

In the past, such dielectrically isolated islands have been formed by thermally growing an oxide layer on a silicon wafer surface and then depositing a relatively thick layer of polycrystalline silicon (polysilicon) over the oxide. The polysilicon layer, sometimes referred to as the handle, is relied upon to provide structural integrity to the overall wafer during subsequent processing. The silicon wafer material is frequently thinned to a thickness of less than 1 mil and polished to provide a starting material for epitaxial silicon growth. This technique is characterized by relatively high temperature processing, consequent high levels of mechanical stress, lattice damage and various nonuniformities across the wafer. See, however, U.S. Patent No. 4,554,059, assigned to the assignee of the present invention, which teaches an electrochemical technique for improving the wafer yield of integrated circuits formed with dielectrically isolated islands.

Several other SOI techniques are of current interest. These include Separation by IMplantation of OXygen (SIMOX), Zone Melt Recrystallization (ZMR), Full Isolation by the Porous Oxidation of Silicon (FIPOS), Silicon on Sapphire (SOS) and bonded wafers. At this time, SOS and bonded wafer technology have advanced sufficiently to realize commercial feasibility.

A feature common to all of the aforementioned SOI technologies is the relatively low thermal conductivity characteristic of the insulator material. Thus, design considerations based on upper limits for steady state operating temperatures of active devices frequently require inclusion of a cooling zone, i.e., additional heat dissipation volume, within each device island. In addition to having a significant impact on the achievable level of device integration, the added volume of semiconductor material can increase parasitic capacitance thereby degrading overall circuit performance. By way of example, consider that the area size of a bipolar transistor island permits a predetermined level of power dissipation beyond which the operating temperature becomes undesirably high relative to ambient conditions. For one known geometry with island dimensions of 51 microns by 43 microns, a temperature rise on the order of 1° C will occur with 1.5 mW of steady state power dissipation. In order to increase the power dissipation to 3.75 mW, while still limiting the temperature to 1° C above ambient, it becomes necessary to increase the island dimensions to 81 microns by 73 microns. That is, approximately 2.5 times the surface area is required in order to dissipate the additional heat. In circuits employing high speed transistors, the required cooling zone can impart other undesirable effects such as parasitic collector-substrate capacitance. Such capacitance such can reduce the circuit frequency response by 20%.

A method according to the preamble of claim 1 and a semiconductor device according to the preamble of claim 4 is disclosed in WO 91/11 822 which has a substrate and an active layer of silicon arranged on the substrate, in which the active layer and the active parts of the device are formed. Between the substrate and the active layer, a layer of diamond is arranged, and between the diamond layer and the active layer, a layer of silicon dioxide is arranged. Optionally a layer of polysilicon is provided between the substrate and the layer of diamond. The semiconductor device disclosed in said reference exhibits good power handling capacities. This reference expressly requires the integrated circuit devices be formed in the active layer because the oxide layer is critical to the structure.

In an article "Total Dose Radiation Hardness of Diamond-Based Silicon-on-Insulator Structures" published in Applied Physics Letters, volume 56, no. 23, p. 2316-2318, by M. I. Landstrass et al. it is disclosed to grow a thin silicon dioxide film on a single-crystal silicon layer before polycrystalline diamond is deposited. Without the thin $SiO_2$ layer, the silicon-insulator interface potential is negatively affected.

From EP-A-0 317 124 a process is known for making a semiconductor structure comprising a single-crystal layer of silicon on a diamond insulator.

From the above it is apparent that competing demands for increased power handling capability and higher levels of device integration require application specific tradeoffs. This is particularly problematic in view of the current trends to develop standard cell libraries and device arrays each suitable for a wide variety of applications.

Accordingly, the present invention provides a method of forming an integrated circuit structure according to claim 1 and a semiconductor structure according to claim 4, respectively.

SUMMARY OF THE INVENTION

There is now provided an integrated circuit structure containing dielectrically isolated islands having heat dissipation paths of enhanced thermal conductivity. Generally, the integrated circuit structure comprises a first layer of crystalline material and a layer of polycrystalline diamond formed thereover. Polycrystalline silicon is formed over the diamond layer and a layer of monocrystalline semiconductor material is formed over the polycrystalline silicon. In the preferred embodiments, the first layer of crystalline material is a single crystal semiconductor material such as silicon or a compound semiconductor; and the layer of nonocrystalline material formed over the polycrystalline silicon is, preferably, a single crystal wafer bonded to the polysilicon. A method for forming an integrated circuit structure having heat dissipation paths of enhanced thermal conductivity includes forming a layer of polycrystalline diamond over a first surface of a layer of substrate material. A polycrystalline silicon layer is formed over the polycrystalline diamond and a layer of monocrystalline semiconductor material is formed over the polycrystalline silicon.

The interest in employing diamond material as a passive component in an integrated circuit structure is, of course, not new. Growth of single crystal diamond films has not been demonstrated. Moreover, significant lattice mismatch has precluded epitaxial growth of silicon films over monocrystalline diamond.

Efforts to use polycrystalline films in order to realize the electrical and thermal benefits of diamond have previously had significant drawbacks that made high volume commercialization difficult. For example, subsequent to deposition of the diamond film on a silicon wafer, a relatively thick, e.g., 20 mil (0,5 mm), polysilicon layer is normally deposited to form a structural backing. Such a backing, or wafer handle, is needed to sustain the integrity of the relatively thin epitaxial silicon layer after thinning or removal of substrate silicon. High temperature processing of the thick polycrystalline handle layer is believed to contribute to wafer warpage.

DESCRIPTION OF THE FIGURES

For a more complete understanding of the invention, reference is made to the following description in conjunction with the accompanying drawings wherein:

Figures 1 through 3 illustrate various stages during formation of a semiconductor structure according to the invention.
Figure 4 illustrates a preferred embodiment of the invention.
Figure 5 is a partial view of an integrated circuit structure according to the invention; and
Figure 6 is a schematic illustration of a circuit formed with the structure of Figure 5.

DETAILED DESCRIPTION OF THE INVENTION

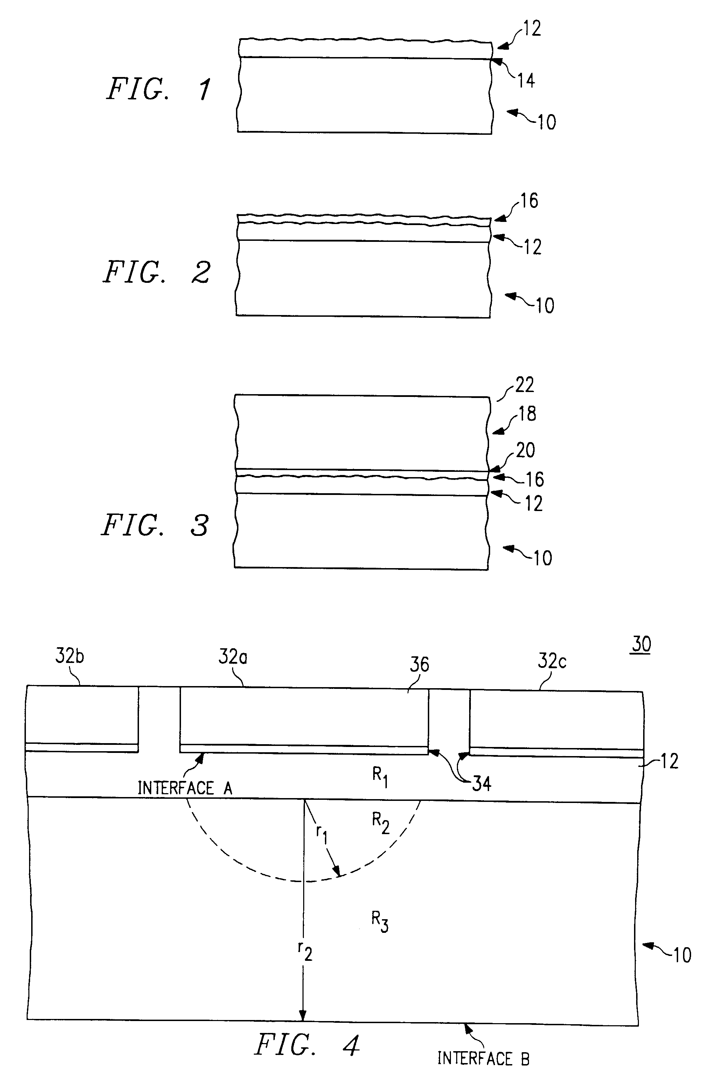

An exemplary process sequence is illustrated in Figures 1-3. Fabrication begins with preparation of a wafer substrate for receiving polycrystalline diamond over a surface thereof. Figure 1 illustrates a monocrystalline silicon wafer 10 having a thin polycrystalline layer 12 formed over a wafer surface 14. For example, a diamond film ranging from 1 to 5 microns in thickness can be deposited by DC, RF or Microwave Plasma Enhanced Chemical Vapor Deposition (CVD) at a deposition pressure ranging from 5 to 100 TORR ($6,66$-$133,3 \times 10^2 Nm^2$) and at a temperature in the range of 600 C to 1000 C. For a more detailed discussion on techniques for forming diamond films on non-diamond substrates, see Zhu, et al. "Growth and Characterization of Diamond Films on Nondiamond Substrates for Electronic Applications" Proceedings of the IEEE, Vol. 79, No. 5, May 1991.

With reference to Figure 2, a thin polycrystalline silicon layer 16, e.g., 1 to 2 microns thick, is next formed over the diamond layer 12. Most preferably, the polysilicon material is formed with a low pressure, chemical vapor deposition technique at a relatively low temperature, e.g., in the range of 600 C. Alternately, the deposition can be had by Plasma Enhanced CVD. Thickness of the polysilicon film 16 could be significantly less than 1 micron, and, for example, on the order of 0.1 micron, depending on the smoothness of the underlying diamond surface. Generally, sufficient polycrystalline silicon is formed over the diamond surface to assure satisfactory bonding of the overall structure with a second wafer. It is desirable to minimize stress effects between the polycrystalline silicon film 16 and underlying material and thereby minimize warpage. The film 16 should therefore be of minimum thickness. Of course, by minimizing surface roughness of the diamond layer 12, one can further reduce the thickness of the polysilicon film 16. Choice of a low deposition temperature when forming the film 16 also reduces residual stress.

Next, the polysilicon film is polished to provide a smooth bonding surface for receiving a second wafer. This can be effected with well known techniques such as with a chemical/mechanical polish employing colloidal silica to provide a planar mirror finish.

A crystalline silicon wafer 18, having a smooth polished surface 20 with planarity comparable to that of the film 16, is then bonded to the polysilicon film 16. See Figure 3. Techniques for bonding a monocrystalline surface with a polycrystalline silicon surface are known. See Jones, et. al., Abstract No. 478, <u>J. Electrom. Soc.,</u> Vol. 138, No. 8, August 1991. Bonding should be preceded by a pre-bond surface treatment consisting of, for example, an $H_2SO_4 \backslash H_2O_2$ cleaning followed by a second cleaning with $NH_4OH$ and a spin rinse/dry. Enhanced bonding between the polysilicon layer 16 and the wafer surface 20 may be had by formation of oxide at the interface. For example, inclusion of a liquid oxidant, such as water, in a high temperature anneal, e.g., above 900 C, in a neutral ambient environment for several hours results in an oxygen bond between lattice silicon and polycrystalline silicon. For further details see U.S. Patent No. 4,962,062 issued October 09, 1990. See, also, U.S. Patent US-A-5 266 135 assigned to the assignee of the present invention, disclosing a preferred liquid oxidant for enhancing bonded wafer yield.

If it is desirable to direct bond the polysilicon layer 16 to the wafer 18 without retaining a residual intervening oxide layer, then such bonding may be accomplished by growing the wafer 18 by the float-zone (FZ) method and allowing only native oxide on the surface of the polysilicon film 16 and the wafer surface 20. The surfaces are placed in contact with one another and the structure is annealed at a high temperature. The native oxide will dissolve into the FZ wafer during the anneal because FZ silicon has an extremely low oxygen content. This method of bonding may be desirable when devices are to be fabricated on the side of the bonded structure containing the polysilicon layer 16.

Devices and circuits may be formed on the bonded wafer structure 22 of Figure 3 with standard processes. Subject to choice of materials, devices may be formed on both the substrate 10 and the wafer 18 of the resulting structure for integrated circuit formation. For example, the wafer layer 18 can be ground back and polished to a thickness on the order of 1 micron for subsequent formation of a heavily doped layer underlying subsequent epitaxial growth. Device formation on the side of the bonded wafer having the polysilicon material between the layer 18 and the diamond layer 12 can enhance circuit performance. That is, the polysilicon will getter metallic impurities and crystalline defects. Moreover, low minority carrier lifetime, a characteristic of the polysilicon region, can minimize photocurrent generation in a transient ionizing radiation environment.

The silicon on diamond structure 22 provides several features advantageous to the planar process. The diamond film is an excellent insulator exhibiting a dielectric constant of 5.5 and an electrical resistivity on the order of $10^{16}$ ohm cm. On the other hand, the diamond film exhibits a thermal conductivity on the order of 20 W/cm K. As indicated in the table below, this provides a substantial improvement over the thermal properties characteristic of other materials used in semiconductor circuits.

| Semiconductor or Insulator Material Type | Thermal Conductivity W/(cm K) |
|---|---|
| Si | 1.4 |
| $SiO_2$ | 0.014 |
| $Si_3N_4$ (silicon nitride) | 0.185 |
| $Al_2O_3$ (sapphire) | 0.3 |
| diamond | 20. |

<u>ADVANTAGES AND MODIFICATIONS</u>

Figure 4 illustrates (not to scale) a SOI structure 30 according to the invention, comprising a plurality of rectangular device islands 32 formed over a layer 12 of diamond insulator. Each device island 32 comprises a lower portion 34 corresponding to the polycrystalline silicon layer 16 and an upper portion 36 corresponding to the bonded wafer layer 18 and epitaxial material formed thereon. The device islands 32 may be considered circular in order to simply illustrate advantages of the invention. Other geometries are more common.

The thermal resistance $R_{AB} = R_1 + R_2 + R_3$, corresponds to a thermal conduction path extending from the interface A, between device island 32a and the diamond layer 12, to an interface B at the lower surface of the crystalline silicon handle substrate 10. Assuming that the interface A is circular, $R_1$ corresponds to the portion of the path extending from the interface A through the diamond layer 12; and $R_2$ corresponds to a hemispherical portion of the path extending into the substrate 10 from the interface between the substrate and the diamond layer 12. In a first order linear approximation, the hemispherical portion is assumed to have a radius $r_1$ equivalent to the radius of a circular interface A with the overlying device island 32a. $R_3$ corresponds to the thermal resistance associated with the remaining thermal conduction path through the substrate 10 to the interface B. The thermal resistances could be approximated as follows:

$$R_1 = \frac{d}{\sigma_1 (\pi r_1^{\,2})}$$

$$R_2 = \frac{r_1}{\sigma_{si}(\pi r_1^{\,2})} = \frac{1}{\sigma_{si}\pi r_1}$$

(linear approximation)

$$R_3 = \frac{1}{2\pi\sigma_{si}} \left( \frac{1}{r_1} - \frac{1}{r_2} \right)$$

wherein:

$d =$     insulator thickness in cm
$\sigma_I =$     insulator thermal conductivity (W/cm K)
$r_1 =$     radius of circular interface A
$r_2 =$     substrate thickness
$\sigma_{si} =$     silicon thermal conductivity

By way of example, there may be an insulator thickness, d, of $2 \times 10^{-4}$ cm, an INTERFACE A radius $r_1$ of $30 \times 10^{-4}$ cm and a substrate thickness, $r_2$, of $254 \times 10^{-4}$ cm. If the dielectric material of the structure 30 was silicon dioxide instead of the diamond layer 12, the resulting thermal resistance $R_{AB}$ would be 614 K/W. However, with the diamond film 12 the thermal resistance of the structure 30 between INTERFACE A and INTERFACE B is only 109 K/W.

For a power dissipation of 3.75 mW, the resulting temperature rise with respect to ambient is on the order of 0.4 C. In contrast, the same power dissipation in a structure formed with silicon dioxide dielectric instead of the diamond layer 12 would exhibit a temperature rise of approximately 2.3 C above ambient.

From the above example, it is apparent that the SOI structure 30 will allow for substantial increases in power dissipation without requiring dedication of additional semiconductor area for thermal dissipation.

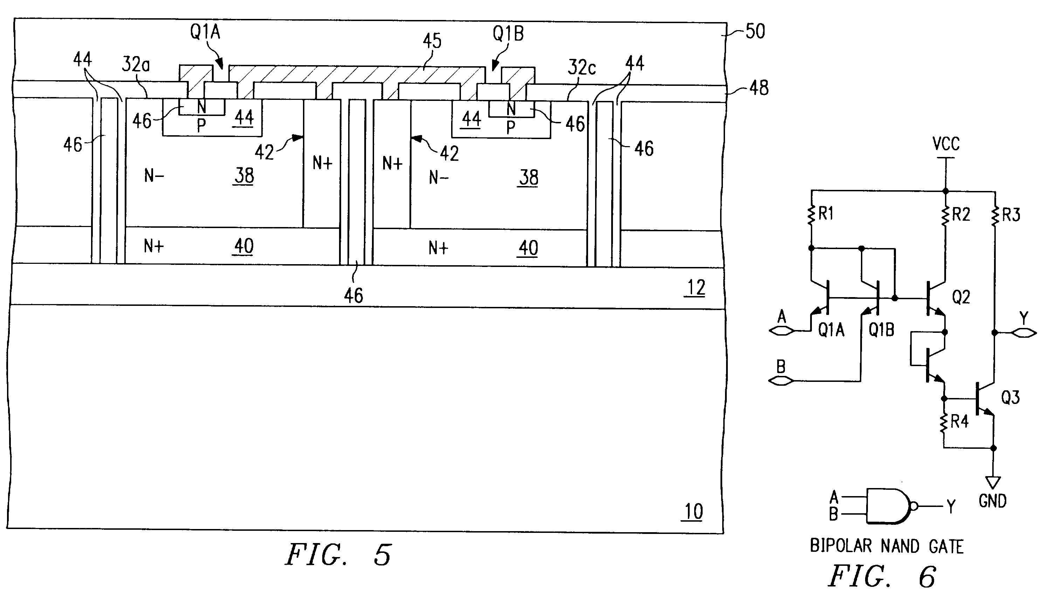

Figure 5 illustrates in partial cross-sectional view integrated circuitry on the structure 30. Devices formed on the islands 32 may be connected into the NAND gate schematically illustrated in Figure 6. With reference to Figures 4, 5 and 6, NAND gate transistor Q1A is formed on island 32a and NAND gate transistor Q1B is formed on island 32c. Each transistor includes a N collector region 38 formed in the monocrystalline upper portion 36 and a buried N$^+$ region 40 formed in polycrystalline silicon lower portion 34. N$^+$ collector contacts 42 extend from the island surface, through the upper portion 36, and down to the buried layer 40. The base regions 44 and emitter regions 46 are formed over the collector regions 38 by implantation and diffusion. Interconnect 45, such as may be formed with a metal level or polysilicon deposition, connects the base region 44 of Q1A to the base region 44 of transistor Q1B. Lateral isolation is provided between the islands 32 with a combination $SiO_2$ 44 and trench filled polysilicon 46, both extending down to the polydiamond layer 12. Further isolation and passivation are provided with a thermally grown oxide layer 48 and a deposited oxide 50, respectively.

Based on the above description, various modifications and alternate embodiments will be apparent. Accordingly, the invention is only to be limited by the claims which follow:

**Claims**

1. A method of forming an integrated circuit structure having a plurality of transistors formed in electrically isolated reins, comprising the steps of:

    providing a crystalline silicon substrate layer (10) having a first surface;
    forming a layer of polycrystalline diamond (12) over the first surface of the substrate layer, said polycrystalline diamond layer having a first surface opposite the first surface of the substrate layer and a second, rough surface;
    forming a thin polycrystalline silicon layer (16) on the second, rough surface of the polycrystalline diamond layer,

forming a layer of monocrystalline semiconductor material (18) over the polycrystalline silicon layer;

characterised by

forming said thin polycrystalline silicon layer to a thickness equal to or less than 2 µm and thick enough to smooth the roughness of the second surface of the polycrystalline diamond layer and thin enough to reduce warping during later thermal processing of the structure; and
forming an integrated circuit structure in said monocrystalline semiconductor material (18).

2. The method of claim 1 wherein the layer of monocrystalline semiconductor material (18) is a wafer predominantly comprising silicon and the step of forming said layer over the polycrystalline silicon layer (16) is accomplished by bonding the wafer to the polycrystalline silicon layer.

3. The method of claim 2, wherein the wafer (18) is bonded to the polycrystalline silicon (16) by forming an intervening oxide of silicon.

4. A semiconductor structure comprising:

a crystalline silicon substrate layer (10) having a first surface;
a layer comprising polycrystalline diamond (12) formed on the first surface, said polycrystalline diamond layer having a first surface opposite the first surface of the substrate layer and a second, rough surface;
a thin polycrystalline silicon layer (16) on the second. surface of the polycrystalline diamond layer (12);
and a layer of monocrystalline semiconductor material (18) formed over the thin layer of polycrystalline silicon (16) characterised by
said thin silicon layer having a thickness equal to or less than 2 µm and thick enough to smooth the roughness of the second surface of the polycrystalline diamond layer and thin enough to reduce warping during later thermal processing of the structure; and
integrated circuit structures being formed in said layer of monocrystalline semiconductor material (18).

5. The structure of claim 4 wherein the layer of monocrystalline semiconductor material (18) includes a first surface bonded to the layer of polycrystalline silicon (16) by intervening oxide bonds.

6. The structure of claim 4 or 5 wherein the layers of polycrystalline silicon (16) and monocrystalline semiconductor material (18) are patterned to form multiple electrically isolated device island, said structure further including a plurality of transistors each formed on a device island, said transistors connected to provide an integrated circuit.

7. The structure of claim 6 wherein the transistors are connected to provide a logic function.

8. The structure of one of claims 4 to 7 wherein the layer of monocrystalline semiconductor material (18) is a crystalline silicon wafer suitable for formation of electronic devices and circuits.

**Patentansprüche**

1. Verfahren zum Herstellen einer integrierten Schaltungsstruktur mit mehreren Transistoren, die in elektrisch isolierten Bereichen ausgebildet sind, mit folgenden Verfahrensschritten:

Vorsehen einer kristallinen Siliziumsubstratschicht (10) mit einer ersten Oberfläche;
Ausbilden einer Schicht aus polykristallinem Diamant (12) über der ersten Oberfläche der Substratschicht, wobei die polykristalline Diamantschicht eine erste Oberfläche, die der ersten Oberfläche der Substratschicht gegenüberliegt, und eine zweite rauhe Oberfläche aufweist;
Ausbilden einer dünnen polykristallinen Siliziumschicht (16) auf der zweiten rauhen Oberfläche der polykristallinen Diamantschicht; und
Ausbilden einer Schicht aus monokristallinem Halbleitermaterial (18) über der polykristallinen Siliziumschicht;

dadurch **gekennzeichnet,** daß

die dünne polykristalline Siliziumschicht mit einer Dicke ausgebildet wird, die gleich oder geringer als 2 µm und dick genug ist, um die Rauhigkeit der zweiten Oberfläche der polykristallinen Diamantschicht zu glätten, und dünn genug ist, um während der späteren thermischen Verarbeitung der Struktur Verwerfungen zu reduzieren; und

eine integrierte Schaltkreisstruktur in dem monokristallinen Halbleitermaterial (18) ausgebildet wird.

2. Verfahren nach Anspruch 1, bei dem die Schicht aus monokristallinem Halbleitermaterial (18) ein Wafer ist, der überwiegend Silizium aufweist, und bei dem das Ausbilden der Schicht über der polykristallinen Siliziumschicht (16) durch Bonden des Wafers auf die polykristalline Siliziumschicht erfolgt.

3. Verfahren nach Anspruch 2, bei dem der Wafer (18) mit dem polykristallinen Silizium (16) verbunden wird, indem Siliziumoxid zwischengeschaltet wird.

4. Halbleiterstruktur mit

einer kristallinen Siliziumsubstratschicht (10) mit einer ersten Oberfläche;

einer Schicht mit polykristallinem Diamant (12), die auf der ersten Oberfläche ausgebildet ist, wobei die polykristalline Diamantschicht eine erste Oberfläche, die der ersten Oberfläche der Substratschicht gegenüberliegt, und eine zweite rauhe Oberfläche aufweist;

einer dünnen polykristallinen Siliziumschicht (16) auf der zweiten Oberfläche der polykristallinen Diamantschicht (12); und

einer Schicht aus monokristallinem Halbleitermaterial (18), die über der dünnen Schicht aus polykristallinem Silizium (16) ausgebildet ist, dadurch **gekennzeichnet**, daß

die dünne Siliziumschicht eine Dicke hat, die gleich oder geringer als 2 μm und dick genug ist, um die Rauhigkeit der zweiten Oberfläche der polykristallinen Diamantschicht zu glätten, und dünn genug ist, um während der späteren thermischen Verarbeitung der Struktur Verwerfungen zu reduzieren; und

daß integrierte Schaltkreisstrukturen in der Schicht aus monokristallinem Halbleitermaterial (18) ausgebildet sind.

5. Struktur nach Anspruch 4, bei der die Schicht aus monokristallinem Halbleitermaterial (18) eine erste Oberfläche aufweist, die durch zwischengeschaltete Oxidverbindungen auf die Schicht aus polykristallinem Silizium (16) gebondet ist.

6. Struktur nach Anspruch 4 oder 5, bei der die Schichten aus polykristallinem Silizium (16) und monokristallinem Halbleitermaterial (18) mit einem Muster versehen sind, um mehrere elektrisch isolierte Bauteilinseln auszubilden, wobei die Struktur ferner mehrere Transistoren aufweist, die jeweils in einer Bauteilinsel ausgebildet sind, und die Transistoren so verbunden sind, daß sie einen integrierten Schaltkreis bilden.

7. Struktur nach Anspruch 6, bei der die Transistoren so verbunden sind, daß sie eine logische Funktion vorsehen.

8. Struktur nach einem der Ansprüche 4 bis 7, bei der die Schicht aus monokristallinem Halbleitermaterial (18) ein kristalliner Siliziumwafer ist, der sich für die Herstellung von elektronischen Bauteilen und Schaltkreisen eignet.

**Revendications**

1. Procédé de formation d'une structure de circuit intégré, comprenant une pluralité de transistors formés dans des régions électriquement isolées, comprenant les étapes consistant à :

- disposer une couche de substrat (10) en silicium cristallin comprenant une première surface ;
- former une couche de diamant polycristallin (12) sur la première surface de la couche de substrat, ladite couche de diamant polycristallin comportant une première surface opposée à la première surface de la couche de substrat ainsi qu'une seconde surface rugueuse ;
- former une couche mince de silicium polycristallin (16) sur la seconde surface rugueuse de la couche de diamant polycristallin ;
- former une couche de matière semi-conductrice monocristalline (18) sur la couche de silicium polycristallin ;

procédé caractérisé par les étapes consistant à :

- former ladite couche mince de silicium polycristallin avec une épaisseur égale ou inférieure à 2 μm et suffisamment épaisse pour lisser la rugosité de la seconde surface de la couche de diamant polycristallin et suffisamment mince pour réduire la déformation pendant le traitement thermique ultérieur de la structure ;
- former une structure de circuit intégré dans ladite matière semi-conductrice monocristalline (18).

2. Procédé selon la revendication 1, dans la lequel la couche de matière monocristalline (18) est une puce contenant en prédominance du silicium et l'étape de formation de ladite couche sur la couche de silicium polycristallin (16) est effectué par liaison de la puce avec la couche de silicium polycristallin.

3. Procédé selon la revendication 2, dans lequel la puce (18) est liée au silicium polycristallin (16) par formation d'un oxyde de silicium intermédiaire.

4. Structure semi-conductrice comprenant :

- une couche de substrat (10) en silicium cristallin comportant une première surface ;
- une couche contenant du diamant polycristallin (12) est formée sur la première surface, cette couche de diamant polycristallin comportant une première surface opposée à la première surface de la couche de substrat et une seconde surface rugueuse ;
- une couche mince (16) de silicium polycristallin sur la seconde surface de la couche de diamant polycristallin, et
- une couche de matière semi-conductrice monocristalline (18) formée sur la couche mince de silicium polycristallin (16),

  structure caractérisée en ce que ladite couche mince de silicium a une épaisseur égale ou inférieure à 2 μm et être suffisamment épaisse pour lisser la rugosité de la seconde surface de la couche de diamant polycristallin et suffisamment mince pour réduire la déformation pendant un traitement thermique ultérieur de la structure, et en ce que des structures de circuit intégré sont formées dans ladite couche de matière semi-conductrice monocristalline (18).

5. Structure selon la revendication 4, dans laquelle la couche de matière semi-conductrice monocristalline (185) comporte une première surface liée à la couche de silicium polycristallin (16) par l'intermédiaire de liaisons d'oxyde.

6. Structure selon une des revendications 4 ou 5, dans laquelle les couches de silicium polycristallin (16) et de matière semi-conductrice monocristalline (18) sont configurées de façon à former de multiples îlots de dispositifs, électriquement isolés, ladite structure comportant en outre une pluralité de transistors formés chacun sur un îlot de dispositif, lesdits transistors étant connectés de façon à créer un circuit intégré.

7. Structure selon la revendication 6, dans laquelle les transistors sont connectés de façon à remplir une fonction logique.

8. Structure selon une des revendications 4 à 7, dans laquelle la couche de matière semi-conductrice monocristalline (18) est une puce en silicium cristallin appropriée pour une formation de dispositifs et circuits électroniques.

FIG. 1

12

14

10

FIG. 2

16

12

10

FIG. 3

22

18

20

16

12

10

FIG. 4

32b

32a

36

32c

30

INTERFACE A

$R_1$

$R_2$

34

12

$r_1$

$r_2$

$R_3$

10

INTERFACE B

FIG. 5

BIPOLAR NAND GATE

FIG. 6